# EUROPEAN PATENT APPLICATION

(11) **EP 0 797 325 A2**
(43) Date of publication of application: **24.09.1997**
(21) Application number: 97200685.2
(22) Date of filing: 07.03.1997
(51) Int. Cl.: H04J 3/06

(54) **Receiver with data frame buffering**

(30) Priority: 22.03.1996 GB 9606084
(71) Applicant: D2B Systems Co. Ltd., Redhill, Surrey RH1 1DL (GB)
(72) Inventor: Hoekstra, Jelle, c/o Patents & Trade Marks Dep., Surrey RH1 5HA (GB)
(74) Representative: White, Andrew Gordon

(57) **Abstract**

A communication system comprises a plurality of nodes (121) coupled to a medium, such as a fibre optic serial data channel (119,111). A source node comprises a transmitter supplied with data frames at regular intervals at a nominal frequency f₁. The transmitter transfers the data contained in the data frames via the medium to receivers at one or more destination nodes, which destination nodes output the data frames at a frequency f₂ (which is of the same order of magnitude as f₁) from a (FIFO) buffer (44) storing data frames received from the source node. The receivers include a control loop (42,44,46), which adjusts the frequency f₂ depending on the filling level of the buffer: if the filling level decreases, the frequency is decreased; if the filling level increases, the frequency is increased. In this way, overflow and underflow of the buffer is avoided and differing internal sample rates for apparatus connected via the nodes and medium may be accommodated.

## Description

The present invention relates to a communication system comprising two or more stations or nodes interconnected for the communication of messages via a medium. More particularly, but not exclusively, the invention relates to interfaces to serial data channels such as fibre optic or copper wire links. The invention further relates to apparatuses for use in such a system.

A serial data system of the above type has been described for example by Knapp and Hetzel in a paper "Audio Local Area Network Chip For Cars", presented at the 92nd Convention of the Audio Engineering Society, 24-27 March 1992, Vienna. Knapp and Hetzel propose use of the well known SPDIF format for the transmission of digital audio signals among the various components of a car audio system , and incorporate within that format eight channels for the transmission of control messages in parallel with the audio signals. Another system of this type is D2B (Domestic Digital Bus) Optical which is a network specification according to which consumer electronic products may be connected to distribute synchronised digital data, such as 16-bit pulse code modulated audio (for example from CD), CD-ROM data, digital audio broadcast (DAB) audio, and digital satellite radio (DSR) audio around an optical fibre loop. Additionally the products can exchange control messages. Note that, despite the name, D2B Optical may also be operated over a copper wire network.

In operation, a source device supplies digital data (primarily audio) to an interface circuit where the data is packaged into frames, each comprising two sub-frames (left/right) of, for instance, 16-bit data. The frames are supplied to the interface at a certain frame rate (fₛ), which depends on the type and source of data. For example, a CD player operates at a frame rate of 44.1KHz. Typically the same clock signal as is used to control the source device hardware (e.g a CD mechanism) is also supplied to the interface circuit. The interface repackages the data in larger frames (providing room for data from other sources, control data, preambles, etc) and sends these larger frames (packets) on the network. The packets are sent at the same frame rate as supplied by the source, but at a higher bit-rate, since a network packet contains more bits. A receiving interface circuit synchronises to the preamble of the packet (using a phase-lock loop), extracts the data and provides that data to the target (destination) device at the same frame rate as originally supplied by the source device.

A D2B Optical network has sufficient capacity to simultaneously support more than one application: for example, in addition to carrying 16-bit audio, in-car navigation systems (16-bit CD ROM) and/or telephone may also be carried. However, the optical fibre (or copper wire) network only operates at one sample rate. For D2B Optical this effectively means that all applications have to operate at the same sample rate which can be a major problem. The dominant sample rate is 44.1KHz but not all products, however, can easily operate at that rate. For example, whilst DAB and DSR can operate at 32 and 38 KHz, digital compact cassette (DCC) operates at 38, 44.1, and 48KHz. On the other hand, there are products that can only operate at 44.1KHz, for example a CD mechanism. In certain systems this could mean that not all capacity can be used.

For audio applications this problem could be solved by using a sample rate converter in one of the products (or even each of them). This has the disadvantage, however, that sample rate converters are very expensive. Furthermore, the source and destination typically can already operate at the same frame sample rate (fₛ) and conversion to another sample rate for transmission over the network will reduce the quality. Moreover, a solution is also required for other applications, such as the transfer of CD-ROM data (for in-car navigation systems) and compressed audio/video, which cannot be sample-rate converted.

An example of a system where data generated at a first sample rate is transmitted over a network at a higher data rate is given in US Patent 4,330,856 (Takasaki et al/Hitachi). The data source writes data into a small buffer at a first bit rate, with the network reading out the data at the (higher) network bit rate. The data in the buffer, when present, is transmitted in the form of distinct codes for "1" and "0": when there is no data in the buffer, a third distinct code indicating "empty" is transmitted. At the destination, the "empty" codes are ignored and the remaining data is buffered. A VCO arrangement clocks the data out of the buffer at a rate determined by the mean data rate of the arriving "1" or "0" codes.

Whilst such a system provides for high speed data transfer between source and destination, with low source/destination buffering requirements, it has a number of disadvantages. Firstly, the asynchronous nature of data bit transmission makes the system unsuitable for synchronous data, particularly where extremely low jitter rates are required (e.g high quality audio). Secondly, the system makes no concession to destination requirements in that the data is read out from the destination buffer at a rate determined by the mean frequency at which the data "1" and "0" bits arrive over the network.

In a further example, US 4,888,768 (Michener/Grass Valley) describes a system wherein a digital video signal is transferred using a telecom network with a higher bandwidth. The sending station inserts a stuff word in each network frame. The stuff word contains valid data if data was still present in the transmission FIFO, otherwise the stuff word comprises garbage bits. The receiving station has an oscillator at the nominal video rate, which is used to read out a receiving FIFO. If the receiving FIFO is full and a newly received stuff word comprises a data bit, the frequency is increased. This "weak" form of synchronisation seeks to avoid an overflow of the receiving FIFO which, for video signals, is sufficient as no accurate bit timing is required. The image is converted to a video signal in video buffer and then displayed and, as long as the overall timing of a video image is roughly accurate, jitter in bit timing will have no consequences. As before, however, the system is unsuitable for high quality audio due to its lack of bit level synchronism.

It is therefore an object of the present invention to reduce the problems due to differing sample rate requirements for devices in local communications systems.

It is a further object of the invention to provide a system which may be arranged to give bit level synchronisation in a frame-based system.

In accordance with the present invention there is provided a communication system comprising a plurality of nodes coupled to a medium and including a source node and one or more destination nodes, wherein said source node comprises a transmitter supplied with data frames at regular intervals at a nominal frequency f₁ and operable to transfer the data contained in the data frames via the medium to said destination node or nodes, the or each destination node comprising a receiver operable to receive the data from the medium and output the data in the form of data frames at regular intervals; characterised in that the or each of said destination nodes further comprises:
a clock signal generator which supplies an output frequency f₂ which is in the same order of magnitude as f₁;
a buffer arranged to store received data frames from the medium and output the data frames; and
a control loop, which adjusts the clock signal generator frequency f₂ depending on the filling level of the buffer such that if the filling level decreases, the frequency is decreased and if the filling level increases, the frequency is increased, wherein the buffer outputs the data frames at the frequency f₂.

Suitably, the destination node clock signal generator is operable to supply at least two different output frequencies f_{2.a},f_{2.b}, with the buffer being arranged to output a threshold signal to the clock signal generator when a predetermined level of fullness is reached, such that the clock signal generator supplies a first of the output frequencies f_{2.a} when the threshold signal is absent and a second of the output frequencies f_{2.b} when the threshold signal is present. As will be described hereinafter, this may be extended to first and second threshold signals at one-quarter and three-quarters buffer fullness with the clock signal generator supplying first, second and third output frequencies.

Suitably, the destination node control loop locks the clock signal generator when the fullness of the respective buffer (preferably having a capacity of greater than one data frame) stabilises at a predetermined level. This improves the stability as minor changes of buffer level do not induce oscillations of the clock signal generator frequency. Larger changes, such as outside the 1/4 or 3/4 thresholds will, however, re-start the control loop.

Further features and advantages of the present invention are recited in the attached claims and will be apparent from reading the following description.

Embodiments of the invention will now be described, by way of example, with reference to the accompanying drawings, in which:
Figure 1 shows in block schematic form a local communication system including interface nodes embodying the present invention;
Figure 2 illustrates the control and source data architecture used in the system of Figure 1;
Figure 3 represents a station with integral interface node;
Figure 4 schematically illustrates one of the interface nodes of Figure 1;
Figure 5 shows the frame structure of digital signals transmitted according to the known SPDIF format;
Figure 6 shows the interface node of Figure 4 in greater detail; and
Figure 7 schematically illustrates multiple channel operation for a system embodying the present invention.

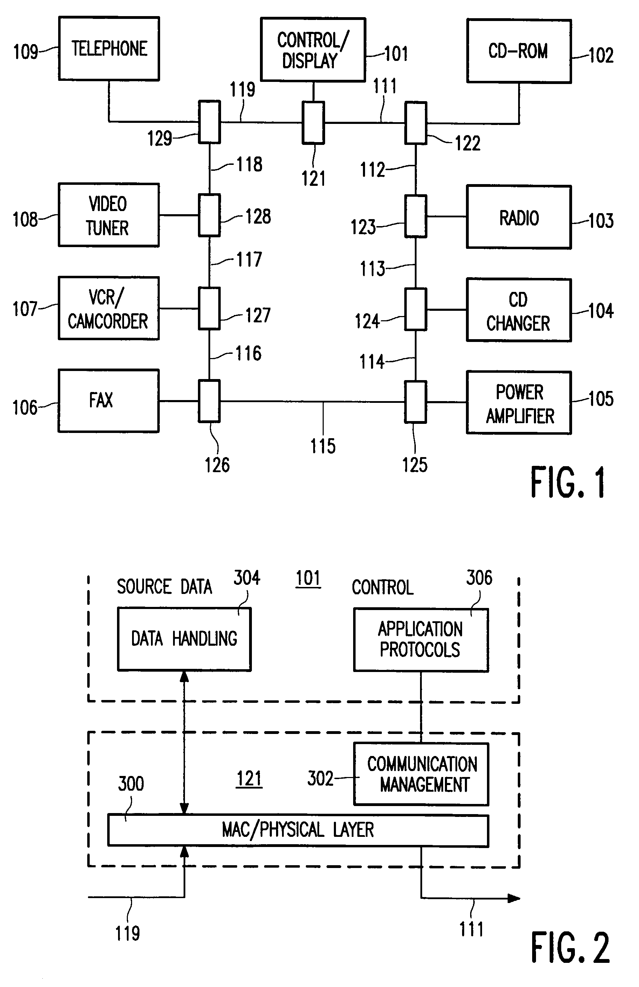

The system illustrated in Figure 1 comprises nine audio-related apparatuses 101-109 connected as stations (or nodes) of a Local Area Network (LAN), although it will become apparent from the following description that many more than nine stations may be accommodated. In this example system, the apparatuses are: a control and display unit 101, a Compact Disc memory (CD-ROM) reader 102, a radio tuner 103, a CD changer unit 104, an audio power amplifier 105, a facsimile send/receive unit (FAX) 106, a video recording system (VCR/CAMCORDER) 107, a video tuner 108, and a telephone 109. The display function of the control and display unit 101 may for example provide for display of information read from memory devices by CD-ROM 102 and/or display of video signals from tuner 108 or VCR 107.

The LAN interconnection comprises nine unidirectional point-to-point fibre optic links 111-119 (although it will be readily understood that copper wire links may instead be used) linking nine substantially structurally identical interface nodes 121-129, such that the nodes are all connected in a ring. Each fibre optic link carries a combination of digital audio/video signals and control messages in accordance with a signal frame structure to be described in detail below. A designated station (referred to hereinafter as the system master), such as the control/display unit 101, continuously generates the frame structure at a frame sample rate of 30-50kHz (preferably 44.1kHz as for CD sampling). One station on the network is designated to act as system master on power-up although, for some applications, the role of system master may subsequently be re-allocated to another station after a period of operation.

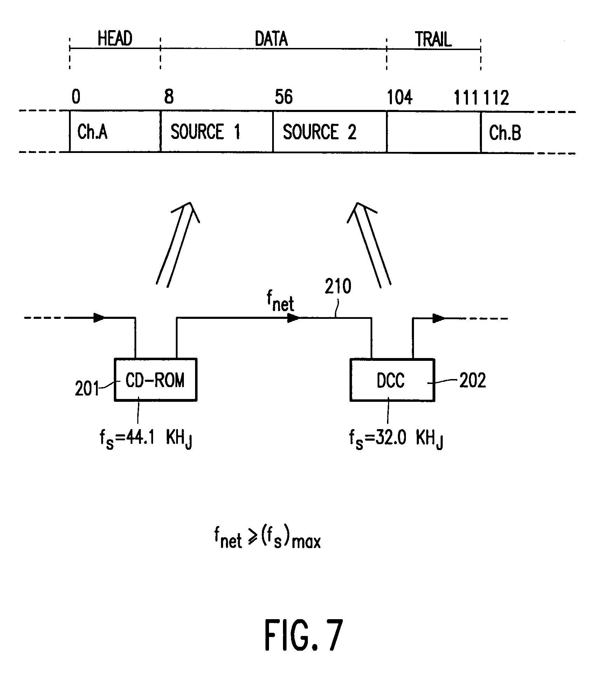

The following paragraphs consider initially the single channel case, with each frame carrying data from a single source for the sake of clarity. The extension to a more adaptable multiple channel system will be described subsequently with reference to Figure 7.

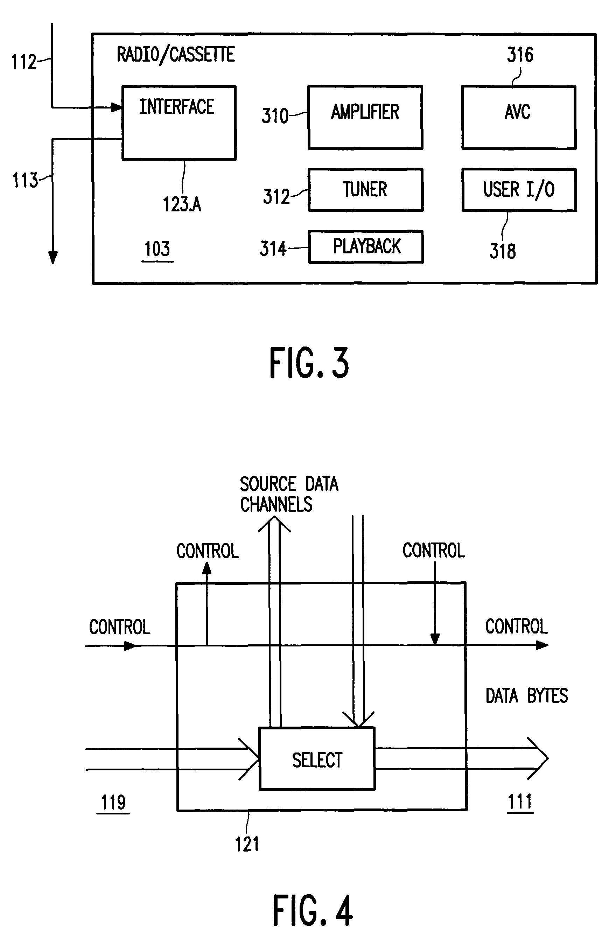

The data architecture of a stations link to the fibre optic ring is schematically illustrated in Figure 2. From the ring 119-111, a media access control (MAC)/physical layer 300 together with a communications management layer 302 for control data are provided in interface node 121. The communications management layer 302 manages address initialisation and verification and ensures the reliable transport of messages by retransmission according to defined timing rules. Data handling for source data 304 and application protocols for control data 306 are provided at station level 101, with the application protocols defining the device/sub-device grouping and control hierarchy for the station, the format of information exchanged between products, the behaviour of devices/sub-devices, and application level timing. It will be readily understood that the interface node 121 may be physically within a station. Figure 3 shows the interface 123A provided within a radio cassette player 103 together with amplifier 310, tuner 312, tape playback deck 314, audio/video controller (AVC) 316 and user I/O 318 sub-devices, which communicate to other stations via the interface 123A. The interconnections of the sub-devices are not shown and have no bearing on the present invention, but will be readily apparent to those of ordinary skill in the art.

Figure 4 is a schematic representation of an interface node (in this case node 121) linking a station to the fibre optic ring. All stations connected to the LAN can generate and receive both source and control data. The control data is of low volume, arrives in bursts and is user/event driven (e.g. user instructions or status changes), whereas the source data is a continuous high volume stream(e.g. audio, compressed video, CD-ROM data).

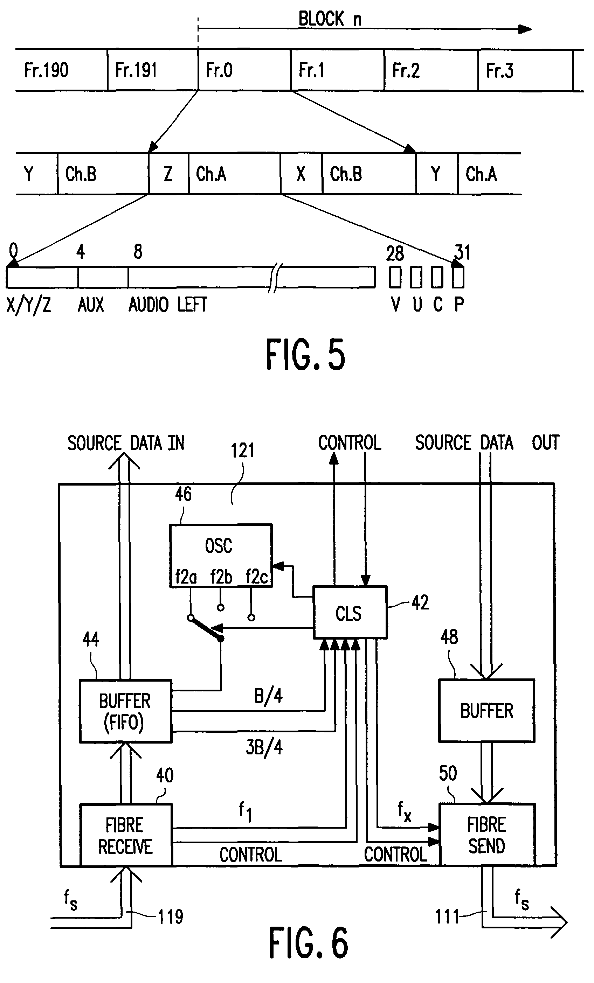

Figure 5 shows a typical structure for a network packet, in this instance according to the Sony-Philips Digital Interface Format (SPDIF), standardised by the International Electrotechnical Commission, Geneva, with reference IEC 958:1989. The SPDIF signal is designed to transfer digital audio signals on a point-to-point link between two products at frame rates of 32kHz, 44.1kHz or 48kHz. The signal is divided into blocks of 192 frames, each frame comprising two sub-frames of 32 bits. Each sub-frame includes a 20-bit field AUDIO carrying audio signal information, and various control and information bit fields, including a preamble X, Y or Z, auxiliary data field AUX, a validity bit V, a user bit U, a channel status bit C and a parity bit P. The SPDIF standard specifies the meanings of all these fields, with the exception of user bit U which is left free for use by the designer of a particular system. In the case of known A-LAN systems, designed to transfer high quality digital audio and control signals to a number of products connected in a ring topology, this user bit U is used for system control.

In order to avoid the problems of differing device sample rates, we have recognised that it is possible is to break the synchronisation chain (source, network, destination) and use independent clocks for source, destination and network. Preferably, the source and destination will operate at the same nominal frequency: this frequency may be sent via the network, for example by sending a control message, or f₂ may be within a preset range with the destination node using a searching control loop to lock onto the actual frequency. A mechanism is used to ensure that both products not only use the same nominal frequency but use the same actual frequency. The network may be either synchronised or not-synchronised. In a synchronised network, a continuous clock signal is present on the network, even if no data is being transmitted. In the case of D2B Optical the clock may be encoded in the data signal, using bi-phase encoding. If no data is available for transmission, an empty data packet (with '0' bytes) is transmitted, maintaining the clock synchronisation. Alternatively, separate clock signals on a dedicated line can be used, as will be understood. For both synchronised and non-synchronised networks the capacity of the network must be higher than the amount of data supplied by the source. For non-synchronised networks, such as packet-switched networks, packets may be transmitted at irregular time intervals. To overcome this irregularity, a significant buffering capacity might be required at the receiver.

For a clock synchronised network, like D2B Optical, the network must operate at the same or (preferably) a higher sample rate (fₛ) than any of the active sources. The source then supplies audio frames to its network interface at its own sampling frequency, and the interface buffers the frames and transmits them in the appropriate network time slot (at the network sampling frequency). Since the network sample frequency is preferably higher, occasionally a slot will remain empty. The source device interface notifies this to the receiving device interface by, for example, padding the frame with a special pattern, using other bits to indicate that the slot is empty, or using frame numbers. The receiving device interface node takes the data from the appropriate time slot and stores it in its buffer. If the time slot is unused, the receiving interface skips the frame. The destination device then reads the data from the receiving interface using its own clock.

Since the clocks for the source and destination will generally operate at a marginally different frequency (within the limits of the local clock signal generator, e.g the tolerance of the crystal in an oscillator) overflow or underflow of the interface node buffer can occur, resulting in loss of data or audible clicks. In order to avoid this, without reinstating the source/network/destination synchronisation chain, the frequency of the destination node is adjusted as will be described below.

Figure 6 shows the node of Figure 4 in greater detail and, where applicable, the same reference numerals are used to denote the same features. Incoming packets on fibre optic link 119 are received by fibre interface 40 at which the control data is separated and passed via an interface control logic stage (CLS) 42 to the destination device. Where supplied, the source device sample frequency f₁ (identified in the control data) is also separated and passed to the CLS 42. The data frames from the incoming packet are passed to a buffer 44 which has a capacity of greater than one data frame. From the buffer 44, the data is then read out to the destination device.

A simple control loop, comprising the buffer 44, CLS 42 and a clock signal generator 46 adjusts the frequency at which frames are read out of the buffer in dependence on the state of buffer fullness. The clock signal generator 46 may be an oscillator driven by a crystal at a nominal frequency f₂ of the same order of magnitude as f₁. Clock frequency f₂ is increased to a maximum value (nominal frequency plus twice the oscillator tolerance) as the buffer gets increasingly full. For relatively simple systems, for example a single audio application determining the network frequency together with data applications using that frequency or lower, this arrangement may be sufficient.

For more complex systems, for example those having more than one audio application (at different frequencies) and/or data applications which would benefit from a higher frequency than determined by the audio application, a slightly more advanced control scheme is provided to reduce jitter. In this case, the buffer 44 is a FIFO register which outputs threshold signals B/4, 3B/4, to the CLS 42 when it is respectively one-quarter and three-quarters full, and the clock signal generator is set to provide one of three frequencies, f_{2.a}, f_{2.b} or f_{2.c} where f_{2.c}>f_{2.b}>f_{2.a}. In the absence of either threshold signal, the buffer is below one-quarter full so that the data is clocked out at the lowest frequency f_{2.a}. When the lower threshold signal is present (buffer between one-quarter and three-quarters full) data is clocked out at f_{2.b}, which is suitably the nominal clock signal generator frequency. Above three-quarters full, the data is clocked out at the maximum frequency f_{2.c}.

Where the clock signal generator is operable to output controllably variable frequency, as opposed to a few discrete values, the control loop may be controlled to lock onto that frequency at which the buffer fullness stabilises. By applying an iterative search algorithm to the changes in f₂ controlled by rate of increase/decrease in buffer fullness the control loop "homes in" on the required value of f₂. Having achieved the steady value of buffer fullness, the control loop is suitably "locked" such that minor changes in buffer level do not re-start the search operation. In such cases, a tolerance range of buffer fullnesses such as steady value ± 10% or outside 25% to 75% of fullness is specified outside of which the deviation is considered sufficiently serious to call for the re-start of the stabilisation procedure.

Typically each interface node will be constructed to act as either a source or destination node with the features of both. Consequently, as shown, an output data buffer 48 is provided between the device data source and sender unit 50 linking the node to an outgoing optical fibre 111. In addition to the source device control signals received via CLS, the sender 50 also receives and incorporates in the outgoing packet an indication of the source device sampling frequency fₓ.

In the event that the node provides a receive-only port, there will be no source data originating from the device and buffer 48 is omitted. Instead, the control and frequency signal lines from fibre receive 40 will connect directly to send unit 50 (as well as to CLS 42) and a data path (not shown) will be provided linking receive and send units 40,50.

As previously mentioned, the foregoing description has covered the single channel case, where all data bits of a frame are utilised by a single source. Figure 7 schematically represents the multi-channel case (two channels shown) where the data bit capacity (DATA) in a D2B Optical subframe is shared between two source devices, CD-ROM 201 operating at sample rate fₛ=44.1KHz and DCC player 202 operating at fₛ=32KHz. The subframe consists of an 8-bit header (HEAD), followed by the DATA section of 96-bits, and the trailing section (TRAIL). The DATA section of the subframe is allocated to the different sources by time-division multiplexing, with the frames being generated on the network or loop 210 at a frequency fₙₑₜ which is greater than or equal to the highest of the source sample rates: in the example shown, fₙₑₜ is at least 44.1KHz.

Whilst described in terms of a local communications system with fixed fibre-optic linkages, it will be readily understood that the above-described techniques may also be applied to other types of communication systems, for example wired networks or digital audio broadcast systems such as GSM, DAB and DSR. Other uses would be in bus architectures such as D2MAC, and multimedia distribution systems in general (for example Philips' Video on Demand system).

From reading the present disclosure, other modifications will be apparent to persons skilled in the art. Such modifications may involve other features which are already known in the field of frame rate buffering apparatuses and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. A communication system comprising a plurality of nodes coupled to a medium and including a source node and one or more destination nodes, wherein said source node comprises a transmitter supplied with data frames at regular intervals at a nominal frequency f₁ and operable to transfer the data contained in the data frames via the medium to said destination node or nodes, the or each destination node comprising a receiver operable to receive the data from the medium and output the data in the form of data frames at regular intervals;
characterised in that the or each of said destination nodes further comprises:
a clock signal generator which supplies an output frequency f₂ which is in the same order of magnitude as f₁;
a buffer arranged to store received data frames from the medium and output the data frames; and
a control loop, which adjusts the clock signal generator frequency f₂ depending on the filling level of the buffer such that if the filling level decreases, the frequency is decreased and if the filling level increases, the frequency is increased, wherein the buffer outputs the data frames at the frequency f₂.

2. A system as claimed in Claim 1, wherein the destination node clock signal generator is operable to supply at least two different output frequencies f_{2.a},f_{2.b}, the buffer is arranged to output a threshold signal to the clock signal generator when a predetermined level of fullness is reached, and the clock signal generator supplies a first of the output frequencies f_{2.a} when the threshold signal is absent and a second of the output frequencies f_{2.b} when the threshold signal is present.

3. A system as claimed in Claim 2, wherein the destination node buffer is arranged to output first and second threshold signals when it is respectively one-quarter and three-quarters full and the clock signal generator is operable to supply a first output frequency f_{2.a} when both threshold signals are absent, a second output frequency f_{2.b} when the first threshold signal is present, and a third output frequency f_{2.c} when the second threshold signal is present, wherein f_{2.c}>f_{2.b}>f_{2.a}.

4. A system as claimed in Claim 1, wherein the destination node control loop is arranged to lock the clock signal generator frequency when the fullness of the respective buffer stabilises at a predetermined level.

5. A system as claimed in any of Claims 1 to 4, wherein the buffer capacity of the or each destination node is in excess of one data frame.

6. A system as claimed in any of Claims 1 to 5, wherein the buffer of the or each destination node comprises a FIFO register clocked at the respective clock signal generator output frequency.

7. A system as claimed in Claim 1, wherein the medium comprises a serial data channel and each node includes interface means thereto.

8. A system as claimed in Claim 7, wherein the nodes are connected in a ring topology by unidirectional fibre optic links.

9. A system as claimed in Claim 1, wherein the source node is operable to inform the destination nodes of the nominal frequency f₁.

10. A system as claimed in Claim 9, wherein the indication of the nominal frequency f₁ of the source node is encoded into one or a succession of the data frames and passed to the or each of the other nodes, with each other node being able to recover the indication of f₁ from the data frames.

11. A system as claimed in Claim 1, comprising two or more source nodes each generating data at a respective source frequency, with data from each of the source nodes time-multiplexed into each data frame, and with f₁ being equal to or greater than the highest of the respective source frequencies.

12. An apparatus for use in a system as claimed in any preceding claim, the apparatus having the technical features of a destination node of the system.

13. An apparatus for use in a system as claimed in Claim 9, the apparatus further having the technical features of a source node of the system.
